# EUROPEAN PATENT SPECIFICATION

(11) **EP 2 248 230 B1**
(45) Date of publication and mention of the grant of the patent: **16.04.2014**
(21) Application number: 08731153.6
(22) Date of filing: 29.02.2008
(51) Int. Cl.: H01R 31/06, H01R 9/24, H05K 7/14, H01R 13/514, H01R 13/60, H01R 13/72

(54) **MODULAR SYSTEM AND RETRACTABLE ASSEMBLY FOR ELECTRONIC DEVICES**
MODULARES SYSTEM UND EINFAHRBARE BAUGRUPPE FÜR ELEKTRONISCHE EINRICHTUNGEN
SYSTÈME MODULAIRE ET ENSEMBLE RÉTRACTABLE POUR DES DISPOSITIFS ÉLECTRONIQUES

(43) Date of publication of application: 10.11.2010
(73) Proprietor: Hewlett-Packard Development Company, L.P., Houston, TX 77070 (US)
(72) Inventor: LEIGH, Kevin, B., Houston, TX 77070 (US)
(74) Representative: Liesegang, Eva
(86) International application number: PCT/US2008/055529
(87) International publication number: WO 2009/108205

(56) References cited:
- WO-A1-2006/069190
- WO-A2-03/003178
- JP-A- 10 042 493
- US-A1- 2004 032 716
- US-A1- 2005 258 721
- US-A1- 2007 230 110
- US-A1- 2007 294 520
- US-B1- 6 459 571
- US-B2- 6 934 786

## Description

### BACKGROUND OF THE INVENTION

### Field of the Invention

The invention relates, in general, to a modular system and a retractable assembly for electronic devices.

### Description of Related Art

Computer related devices, such as servers or storage units, often are arranged in modular systems. Such modular systems can be configured to allow a user to readily access a relatively large number of electronic devices in the modular system for maintenance or upgrade purposes. The electronic devices can be held by a frame in a cage or chassis and are accessible through the front face of the chassis. A typical modular system may be, for example, a storage blade module, a rack-mount server, a tower server, or a desktop workstation. For example, blade systems may house several independent servers within a chassis that supplies shared power and networking infrastructure. A blade chassis most likely has a width and depth confined by the industry standard rack frame sizes. A typical blade chassis has a depth of more than 30" and a width of about 17", and the height can vary.

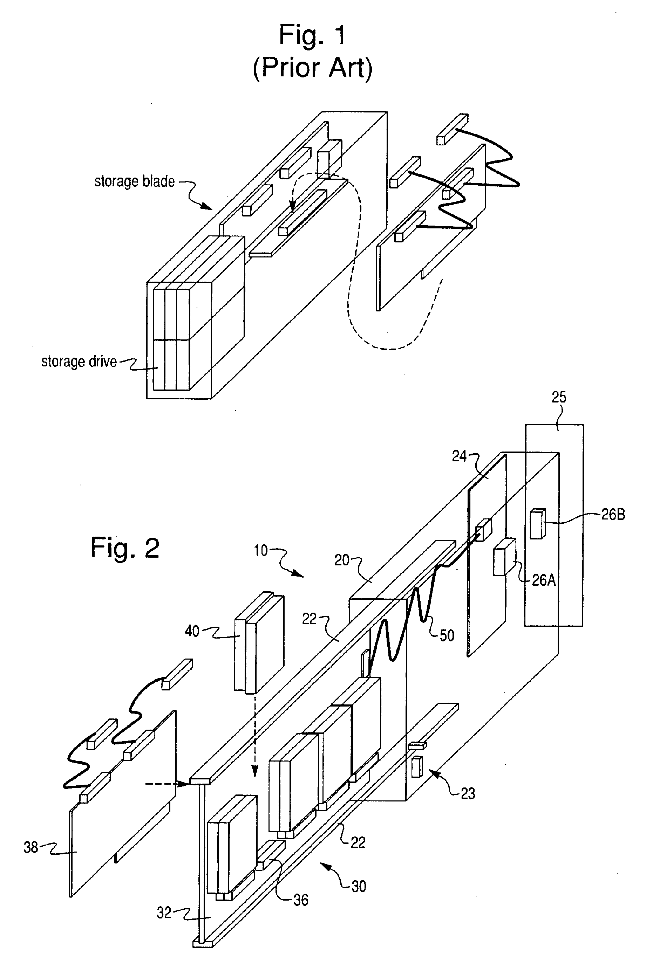

Current storage blade systems can include a front panel with a fixed number of bays for electronic devices, such as storage drives. For example, a front panel may have six front drive bays that accommodate six drives. FIG. 1 shows an example of a conventional storage blade for a modular system. The storage blade is a generally elongated structure that includes a plurality of storage or disk drives (for example, 2.5" or 3.5" disk drives), arranged in a series of openings or bays on the front of the storage blade. Traditional 3.5" drives with carriers require front-loading for a traditional usage model in data centers. Because the drives are shorter than the storage blade, a relatively large amount of space (that is behind the drives but within the blade) is unoccupied, save for a few components such as a base board and controller cards. Thus, the capacity of the storage blade is limited by the size of the front panel (for example, the exposed face) of the storage blade and by the number of electronic devices that can be housed near the access space on the front panel. If such a conventional blade were to house an electronic device in the rear, that electronic device would only be accessible by pulling the blade from its modular frame, thus severing the electrical connection between the electronic device and a modular frame housing the blade. Furthermore, due to the relatively short depth of 2.5" drives, an even greater volume of space is wasted behind those disk drives than there is with 3.5" drives. Additionally, a different storage blade must be designed to accommodate different drive form factors (for example, 2.5" vs. 3.5" storage blades).

Other conventional systems, such as storage shelves, may have a retractable sub-cage that holds several drives. The controller for the drives often is located in the base board of a main cage rather than the sub-cage, and an electrical connection for the drives is not maintained when the sub-cage is extended or retracted. Furthermore, the retractable sub-cage may have a bulky cable assembly that requires a large mechanism, such as an accordion-style arm or double-reel spool, which can take up significant amount of space and can be expensive.

Because disk drives are increasing in capacity and decreasing in form factor, the density of these devices within servers is becoming higher. However, the server density is limited by the amount of space available within a server and the number of drives that can be arranged within this space so that the drives are secured and easily accessible. Therefore, it would be advantageous to provide a modular system that allows for an increased number of storage drives or other electronic devices.

A modular system which is adapted to receive a plurality of electronic devices is known from US 2007/0230110 A1. Electronic devices may be connected to a retractable device which in turn may be connected via a flex cable to back plane connector.

From US 6,459,571 B1, a retractable device is known which is configured to receive a plurality of electronic devices. The retractable device may be connected to a power supply and controller unit via a connector and in addition via a cable. When the retractable device is retracted the connection via the connector is broken and the electronic devices remain connected to the power supply and controller unit via the cable.

In JP 10042493A a retractable device is disclosed which communicates via an optical connection.

A cable management rack that connects an electronic device to a frame is disclosed in US 2005/0258721A1.

With the rapid rate of silicon technology advancements, System-on-Chip components are now becoming very capable with integrated memory controllers, multiple 10 Gigabit Ethernet ports, storage controllers and generic I/O bus controllers, all in a single chip. A server form factor then can become as small as or smaller than a 2.5" hard disk drive. These very small form factor (micro) servers can be modular within a larger blade form factor. Without a retractable assembly, servicing these micro servers within a larger blade form factor. Without a retractable assembly, servicing these micro servers within a larger blade shell will require the entire blade to be removed, and thus severing the power and signal connectivity to all the micro server modules within the blade. Therefore, it would be advantageous to provide a modular system that allows for servicing a micro server module within a blade without affecting the other micro server modules.

### SUMMARY OF THE INVENTION

According to an embodiment, a retractable assembly for electronic devices includes at least one retractable device configured to extend from and retract into a frame. The retractable device is configured to hold at least one electronic device. The retractable assembly further includes a connection device configured to form an interface between at least one of the electronic device and the retractable device and at least one of the frame and a component of a modular system for housing the retractable assembly. The connection device is configured to maintain the interface when the retractable device is both extended from and retracted into the frame.

According to another embodiment, a modular system for electronic devices includes a frame configured to house a plurality of retractable assemblies and a plurality of retractable assemblies. Each of the retractable assemblies includes at least one retractable device configured to extend from and retract into a frame of the retractable assembly. The retractable device is configured to hold at least one electronic device. The retractable assembly further includes a connection device configured to form an interface between at least one of the electronic device and the retractable device and at least one of the frame of the retractable assembly and a component of the modular system. The connection device is configured to maintain the interface when the retractable device is both extended from and retracted into the frame.

### BRIEF DESCRIPTION OF THE DRAWINGS

The accompanying drawings, which are incorporated in and constitute a part of this specification, illustrate embodiments of the invention and together with the description serve to explain principles of the invention.
FIG. 1 is an isometric view of a prior art storage blade.
FIG. 2 is an isometric view of a retractable assembly including electronic devices arranged on a retractable device according to an embodiment of the invention.
FIG. 3 is an isometric view of a retractable assembly including electronic devices arranged in multiple rows on a retractable device according to an embodiment.
FIG. 4 is an isometric view of a retractable assembly including electronic devices arranged in multiple rows on a retractable device according to an embodiment.
FIG. 5 is an isometric view of a retractable assembly including electronic devices arranged in multiple rows on a retractable device with multiple intermediary devices and retractable cable assemblies according to an embodiment.
FIG. 6 is an isometric view of a retractable assembly including electronic devices arranged in multiple rows on a retractable device with multiple intermediary devices and a single retractable cable assembly according to an embodiment.
FIG. 7 is an isometric view of a retractable assembly including electronic devices arranged on a plurality of retractable devices according to an embodiment.
FIG. 8 is an isometric view of the retractable assembly of FIG. 7 showing the interface between the retractable devices and the base.
FIG. 9 is an isometric view of a modular system containing a plurality of retractable assemblies, such as those shown in FIGS. 2-8, according to an embodiment.

### DETAILED DESCRIPTION OF PREFERRED EMBODIMENTS

Presently preferred embodiments of the invention are illustrated in the drawings. In the drawings, an effort has been made to use like numerals to represent like parts.

A modular system can include one or more retractable assemblies for electronic devices. The retractable assembly can include, for example, at least one retractable device configured to hold at least one electronic device (e.g., a storage drive, a micro server module, or other device) and configured to extend from and retract into a frame. The retractable assembly also can include a connection device configured to form an interface between at least one of the electronic device and the retractable device and at least one of the frame and a component of the modular system. The modular system and retractable assembly can be configured, for example, to maximize the volume that can be occupied by the electronic device(s).

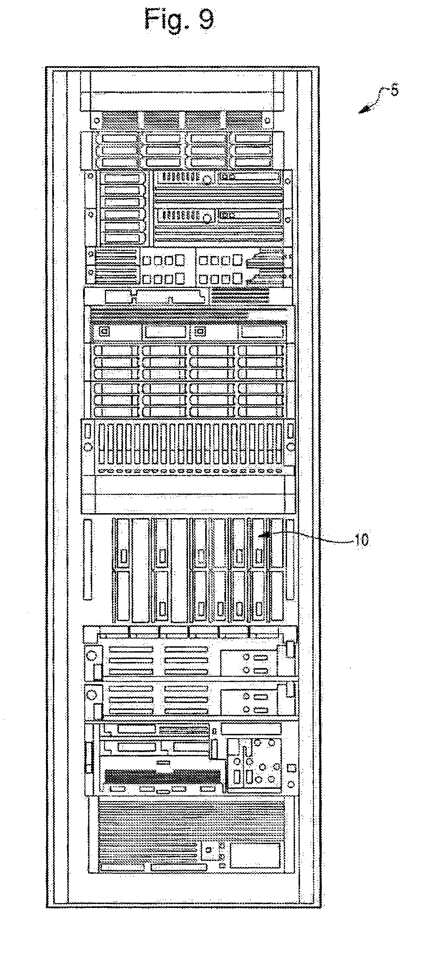

FIGS. 2-8 show embodiments of retractable assemblies 10. One or more retractable assemblies 10 can be housed in a frame of a modular system 5, an embodiment of which is shown in FIG. 9. While the retractable assemblies, drives, and printed circuit boards of FIGS. 2-8 are generally illustrated in a vertical (for example, up and down) orientation, it should be understood that they could be oriented in other orientations, such as, for example, a horizontal orientation, and that the present disclosure is not limited to any particular orientation.

An embodiment of such a retractable assembly 10 is shown in FIG. 2. It can include a frame 20 (for example, a cage, chassis, housing, etc.). As shown in this embodiment, the frame 20 may be configured for a storage blade.

As also shown in FIG. 2, the retractable assembly 10 can include blade or a retractable device 30 that is moveable with respect to the frame 20. The retractable device 30 can be, for example, a tray or other retractable body that can be retracted into the frame 20 and can be extended from the frame 20. For example the retractable device 30 can be configured to extend from and retract into a cavity located within the frame 20. More particularly, the retractable device 30 can include a main board 32 (for example, a printed circuit board) mounted on structure (such as rails 22) that permits a moveable interface or connection to the frame 20. Although only one retractable device 30 is shown in FIGS. 2-6, it should be understood that a retractable assembly 10 may include multiple retractable devices 30.

The retractable device 30 can hold one or more electronic devices 40, one or more connectors 36 that connect to the electronic devices 40, and one or more intermediary devices 38. The retractable device 30 (and/or frame 20) can include ejection buttons, status LEDs, ventilation grills or other features arranged near each electronic device 40. As shown in FIG. 2, the electronic devices 40 can be arranged, for example, substantially parallel to the main board 32 along the depth of the main board 32 and coupled to main board 32 with the connectors 36.

According to the embodiment shown in FIG. 2, the electronic devices 40 are 2.5" drives. According to other embodiments, however, various other suitable electronic devices could be utilized, such as hard disk storage devices (such as, for example, electromagnetic storage devices), solid-state memory storage devices, miniature computers, micro server modules (such as those using system-on-chip (SoC) technology), input/output devices, memory subsystem modules (such as dynamic random access memory (DRAM) modules), and other electronic devices known in the art.

According to the embodiment shown in FIG. 2, the intermediary device 38 can be configured to perform a control function for the electronic devices 40, and/or to perform a switching function with electronic devices 40, such as routing information between the electronic devices 40 and/or between the electronic devices 40 and the modular housing 20. As a particular example, the intermediary device 38 can be a storage controller card.

The intermediary device 38 can be coupled to the main board 32 with a conventional connector, such as PCI Express (not shown). The intermediary device 38 can include one or more devices. As shown in the examples of FIGS. 2-6, the intermediary device 38 may be arranged in an orientation that is substantially parallel to the main board 32 and coupled to the opposite side of main board 30 from electronic devices 40. According to other embodiments, the intermediary device 38 may be arranged in other orientations or sides relative to the main board 32. As will be understood by those skilled in the art, various configurations are possible with retractable assembly 10. According to other embodiments, the intermediary device 38 does not have to be provided as a separate component, but instead may be installed directly onto the main board 32 (such as, for example, as a microprocessor chip, a switching chip, or a microcontroller, etc).

The retractable assembly 10 also can include a connection device 50 that is configured to provide an interface between at least one of the electronic device and the retractable device and at least one of the frame and a component of the modular system, when the retractable device is both extended from and retracted into the frame. The interface can be, for example, electrical or optical in nature. Preferably the connection device 50 maintains the interface at least through the point of maximum extension of the retractable device 30 from the frame 20. A connection device 50 can be used, for example, to electrically or optically couple the retractable device 30 (including the electronic devices 40) to at least one of the frame 20 and the modular system 5 for housing the retractable assembly. For example, the connection device 50 may couple the retractable device 30 to a base board 24 on the frame 20. Base board 24 may further include a backplane connector 26A that couples the frame 20 to other components in the modular system 5. For example, the backplane connector 26A can couple the frame 20 to a backplane 25 via a backplane connector 26B of the backplane, as shown in FIG. 2. The connection device 50 can provide power and data transmission between the retractable device 30 and the frame 20. The connection device 50 can include, for example, an electrical cable (such as a flexible cable), an optical cable, an optical connection (such as an optical waveguide or a line of sight light connection system (such as one that uses free space optics)), or any other suitable coupling mechanism. According to one embodiment, the connection device 50 is a PCI Express cable interface.

The arrangement of the electronic devices 40 on the retractable device 30 allows for maximization of the use of the volume space of the retractable device 30, especially the depth, thus providing an efficient arrangement of a plurality of hot-plug, hot-replaceable electronic devices 40 while requiring a minimum amount of space on the front of the frame 20. The retractable device 30 also advantageously permits more electronic devices 40 to be used while maintaining an interface when the assembly 30 is extended to provide access to the electronic devices 40. Furthermore, coupling the intermediary device 38 to the retractable device 30, such that it is retracted and extended with retractable device 30, and coupling retractable device 30 to the frame 20 with the connection device 50 allows a minimum amount of signals to be routed between the base board 24 and the retractable device 30. Fewer signals enable the use of a smaller cable for routing between the retractable device 30 and the base board 24.

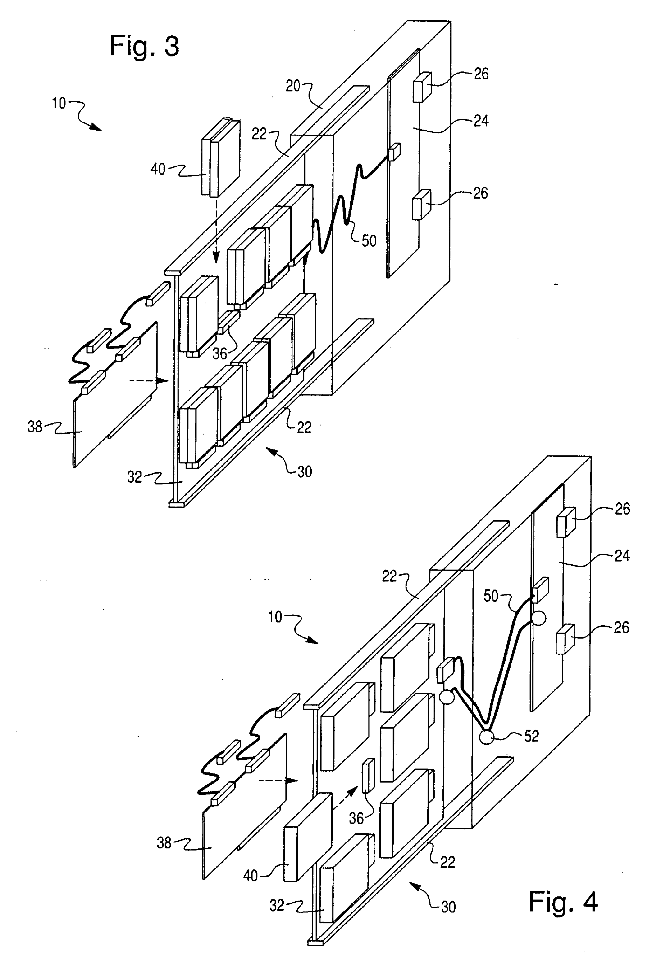

FIG. 3 shows an example of a retractable assembly 10 that is similar to the retractable assembly 10 of FIG. 2. As shown in FIG. 3, the frame 20 may be configured as a full-height storage blade and the retractable device 30 may be sized to receive multiple rows of electronic devices 40. While the retractable device 30 may be larger than shown in the example of FIG. 2, the same intermediary device 28, electronic devices 40, and connection device 50 may be used.

Referring to FIG. 4, a retractable assembly 10 is shown that is configured to include a plurality of electronic devices 40, such as, for example, 3.5" storage drives. While the modular system of FIG. 4 can include different electronic devices than the modular system of FIGS. 3, the same base board 24, intermediary device 28, and connection device 50 may be used. As shown in FIG. 4, the retractable assembly 10 may further include an additional mechanical coupling device, such as, for example, a retracting arm 52. This retracting arm 52 can be configured to limit extension of the retractable device 30 beyond a predetermined point.

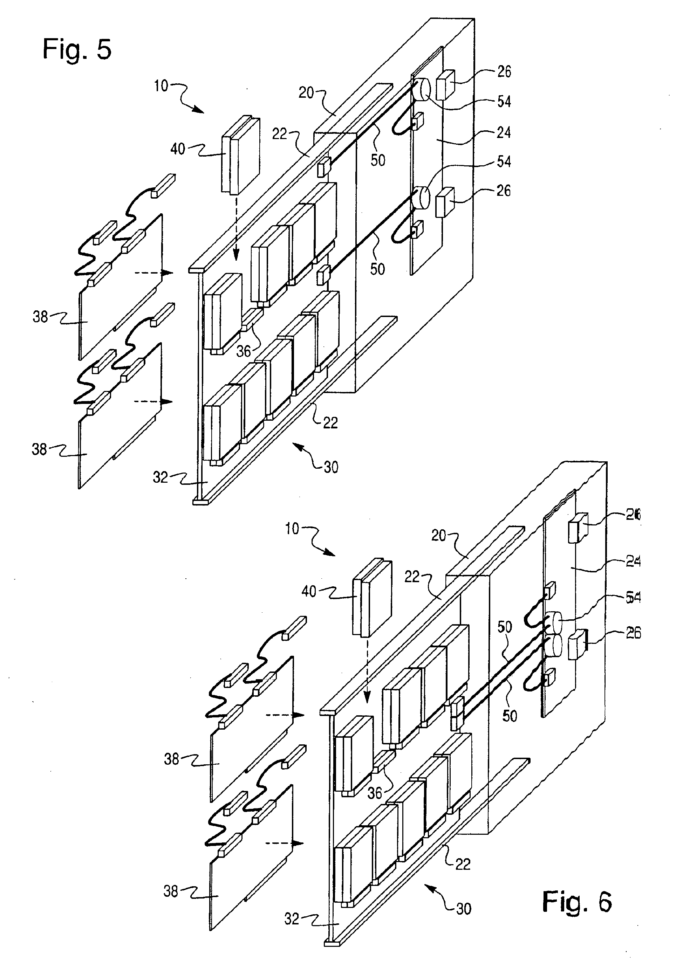

As shown in the examples of FIGS. 5 and 6, the retractable assembly 10 may include multiple retractable connection devices 50 and multiple intermediary devices 38 on the retractable device 30. A retractable mechanism 54 can be provided to release a cable of the connection device 50 when the retractable device 30 is extended, and retract and house the cable when the retractable device 30 is retracted. A suitable retractable mechanism 54 is known to persons skilled in the art. Each retractable connection device 50 may be associated with a corresponding retractable mechanism 54, as shown in the example of FIG. 5, or multiple connection devices 50 may be associated with a single retractable mechanism 54 as shown in the example of FIG. 6. A common retractable cable mechanism 54 also can be configured to provide tension control for the connection device 50. For example, a spring-loaded reel assembly can be configured within the retractable mechanism 54 to provide tension that provides a biasing tension to retract a cable and the retractable device 30. To minimize damaging the connection device 50 when the retractable device 30 is extended farther than a maximum length of the connection device 50, the retractable mechanism 54 may include a break-free mechanism on one side of retractable mechanism. As used herein, a break-free mechanism refers to a device that is configured to break free or disconnect rather than permit failure of components when more than a predetermined amount of force is applied to the retractable mechanism 54. For example, the retractable device 30 can be configured to be disconnected from the corresponding connector to prevent failure of the retractable mechanism 54 or the corresponding connectors. Alternatively, the retractable device 30 can be stopped by using a mechanical feature on the slide 22 and in the blade 20, to prevent the retractable assembly to be retracted beyond a predetermined point. For example, a retractable assembly 10 can include a mechanical stop 23 that limits the extension of the retractable device 30, as shown in the example of FIG. 2.

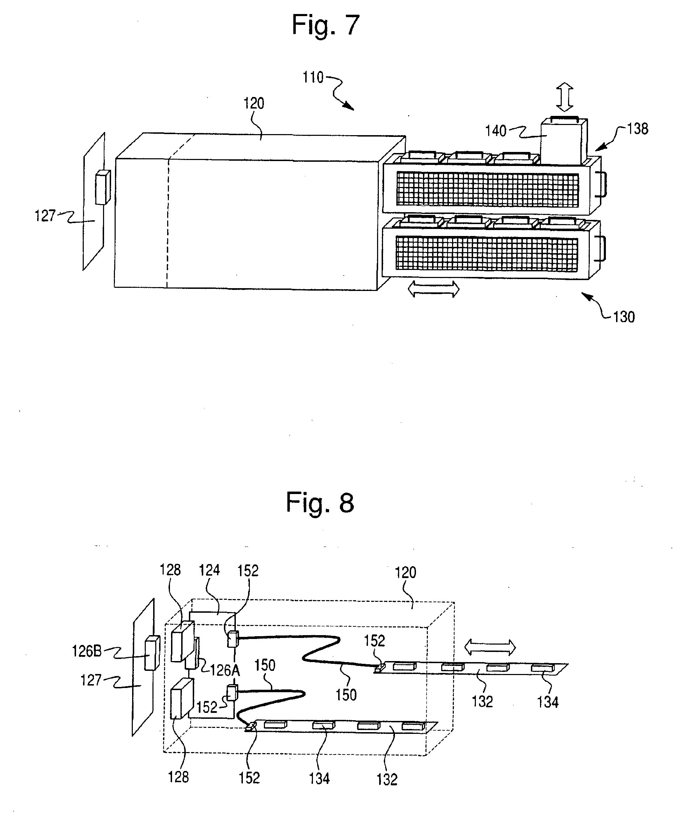

Referring to FIGS. 7-8, a retractable assembly 110 is shown according to another embodiment. The embodiment of FIGS. 7-8 is similar in many respects to the embodiments of FIGS. 2-6, except it includes multiple retractable devices 130. For example, the retractable assembly 110 can be a rack-mounted server or blade enclosure that is configured to fit a plurality of electronic devices 140, such as, for example, hot-plug hard disk drives, within a volume of space with a minimum front or rear access area. This arrangement of the drives minimizes wasted volume space within a rack-mount server or a blade enclosure, as there is more space in a rear portion of a rack-mount server or blade enclosure than the space that is accessed through a front face of the rack-mount server or blade enclosure.

Retractable assembly 110 can include a frame 120 (for example, cage, chassis, housing, etc.) and a retractable device 130 that is moveable with respect to frame 120. As shown, frame 120 can be, for example, a storage tray. The retractable device 130 can be, for example, a tray or other retractable body. The retractable device 130 can be configured to extend from and retract into a cavity within the frame 120. Rails or other devices can be provided as means for extending and retracting the retractable device 130. The retractable device 130 can hold a plurality of electronic devices 140. For example, the retractable assembly 110 can be configured to receive a plurality of 2.5" or 3.5" drives. According to other embodiments, the modular system may be configured to hold other suitable electronic devices (such as, for example, electronic storage devices, miniature computers, micro server modules, input/output devices, memory subsystem modules, etc.). Although only two retractable devices 130 are shown in the examples of FIGS. 7-8, it should be understood that retractable assembly 110 may include additional retractable devices 130.

Each retractable device 130 can include, for example, a printed circuit board (PCB) 132 with a number of connectors and a number of electronic devices 140. Each electronic device 140 can be received in a slot or bay 138 in the retractable device 130 and can be coupled to the board 132 with connectors 134. The retractable device 130 may further include other features, such as, for example, ejection buttons, status LEDs, and/or a ventilation grille arranged near each drive slot 138. Handles and/or status displays (for example, using LED's/LCD), and air grills may be provided on the front face of the retractable device 130.

According to various embodiments, the electronic devices 140 may be bare or include a carrier with a handle. For example, if two retractable devices 130 are provided, then either the top or the bottom device 130 may be extended individually so that all electronic devices 140 on the retractable device 130 may be accessed. The retractable device 130 may be configured such that the back of electronic devices 140 can be accessed for servicing, after opening a side panel of the housing 120. Individual electronic devices 140 may also include eject buttons, levers, handles, status LED's, and/or other features known in the art. The number of retractable devices 130 in the retractable assembly 110 and the number of electronic devices 140 in each retractable device 130 can vary, depending on the application. Each retractable device 130 may include ventilation grills as needed.

A connection device 150, such as, for example, an interface cable, can couple the retractable device 130 to at least one of frame 120 and the modular system 5 for housing the retractable assembly to form an interface. The interface can be, for example, electrical or optical in nature. The connection device 150 can have the same features as the connection device 50 discussed above. The connection device 150 can provide power and data transmission between the retractable devices 130 and frame 120. The connection device 150 may be, for example, an electrical cable (such as a flexible cable), an optical cable, an optical connection (such as an optical waveguide or a line of sight light connection system (such as one that uses free space optics), or any other suitable connection mechanism, such as those described above for the connection device 50. The electrical connection 150 may be coupled, for example, on one end to the board 132 on the retractable device 130, and on the other end to a base board 124 on the frame 120. The electrical connection 150 can be coupled to the boards 124 and 132 with interface connectors 152. The interface connectors 152 can contain necessary interface signals for all the electronic devices 140 and the retractable device 130.

Cooling fans 128 may be provided within the frame 120 proximate to the base board 124 or may be provided within the retractable device 130, as permitted by the application. The base board 124 may further include a backplane connector 126A that couple the frame 120 to the backplane 127 via a backplane connector 126B of the backplane 127.

An intermediary device can be configured to perform a control function with electronic devices 140, and/or to perform a switching function with electronic devices 140, such as routing information between the electronic devices 140 and/or between the electronic devices 140 and the modular housing 120. The intermediary device (not shown) is a part of the retractable device 130 and coupled to board 132.

The same frame 120 may be used for various electronic devices of different sizes, such as, for example, 2.5" or 3.5" storage drives. Different retractable devices 130 can be provided to accommodate the various electronic devices and various sizes of electronic devices. Furthermore, the retractable assemblies 110 of FIGS. 7-8 can include any of the features described herein for the retractable assemblies 10 of FIGS 2-6.

The foregoing description of embodiments of the invention has been presented for purposes of illustration and description. It is not intended to be exhaustive or to limit the invention to the precise form disclosed, and modifications and variations are possible in light of the above teachings or may be acquired from practice of the invention. The embodiments were chosen and described in order to explain the principals of the invention and its practical application to enable one skilled in the art to utilize the invention in various embodiments and with various modifications as are suited to the particular use contemplated. Other embodiments of the invention will be apparent to those skilled in the art from consideration of the specification and practice of the invention disclosed herein.

## Claims

1. A retractable assembly (10) for electronic devices, comprising: at least one retractable device (30) configured to extend from and retract into a frame (20), wherein the retractable device (30) includes a board (32) configured to hold at least one electronic device, and a connection device configured to form an interface between the retractable device (30) and at least one of the frame (20) and a component of a modular system (5) for housing the retractable assembly (10), wherein the connection device (50) is configured to maintain the interface when the retractable device is both extended from and retracted into the frame (20), and **characterized in that** said retractable assembly (10) further comprises an intermediary device (38) configured to perform at least one of a control function with the electronic device (40) and a switching function with the electronic device (40), wherein the intermediary device (38) is connected to the board (32) of the retractable device (30) so that the intermediary device (38) extends and retracts with the retractable device (30).

2. The retractable assembly (10) of claim 1, further comprising the frame (20), wherein the frame (20) is configured to be housed within the modular system (5), wherein the retractable device (30) is configured to extend from an interior of the frame (20) and retract into the interior of the frame (20).

3. The retractable assembly (10) of claim 1, wherein the intermediary device (38) is at least one of a microprocessor chip, a switching chip, and a microcontroller.

4. The retractable assembly (10) of claim 1, wherein the connection device (50) includes an electronic device that is configured to electrically connect the retractable device (30) to at least one of the frame (10) and the modular system (5).

5. The retractable assembly (10) of claim 4, wherein the connection device (50) includes a break-free connection.

6. The retractable assembly (10) of claim 1, wherein the connection device (50) includes at least one of an optical waveguide and free space optics.

7. The retractable assembly (10) of claim 1, wherein the electronic device (40) is at least one of a hard disk storage device, a solid-state memory storage device, a miniature computer, a micro server module, input/output device, and a memory subsystem module.

8. The retractable assembly (10) of claim 1, further comprising a front panel that includes at least one of a button, a display, a vent, and a handle.

9. The retractable assembly of claim 1, wherein the retractable assembly (10) comprises at least one of a server and a storage shell.

10. The retractable assembly (10) of claim 1, further comprising a mechanical stop that limits the extension of the retractable device.

11. A modular system (5) for electronic devices (40), comprising: a frame (10), and a plurality of retractable assemblies (10) according to claim 1, wherein the plurality of retractable assemblies (10) are housed in the frame (10).

## Patentansprüche

1. Zurückziehbare Baugruppe (10) für elektronische Vorrichtungen, umfassend: mindestens eine zurückziehbare Vorrichtung (30), die konfiguriert ist, sich von einem Rahmen (20) zu erstrecken und sich darin zurückzuziehen, wobei die zurückziehbare Vorrichtung (30) eine Platte (32) enthält, die konfiguriert ist, mindestens eine elektronische Vorrichtung zu halten, und eine Verbindungsvorrichtung, die konfiguriert ist, eine Schnittstelle zwischen der zurückziehbaren Vorrichtung (30) und mindestens einem von dem Rahmen (20) und einer Komponente eines modularen Systems (5) zum Unterbringen der zurückziehbaren Baugruppe (10) zu bilden, wobei die Verbindungsvorrichtung (50) konfiguriert ist, die Schnittstelle aufrechtzuerhalten, wenn die zurückziehbare Vorrichtung sich sowohl vom Rahmen (20) erstreckt als auch darin zurückgezogen ist, und **dadurch gekennzeichnet, dass** die zurückziehbare Baugruppe (10) ferner eine Zwischenvorrichtung (38) umfasst, die konfiguriert ist, mindestens eins von einer Steuerfunktion mit der elektronischen Vorrichtung (40) und einer Schaltfunktion mit der elektronischen Vorrichtung (40) auszuführen, wobei die Zwischenvorrichtung (38) mit der Platte (32) der zurückziehbaren Vorrichtung (30) verbunden ist, sodass sich die Zwischenvorrichtung (38) mit der zurückziehbaren Vorrichtung (30) erstreckt und zurückzieht.

2. Die zurückziehbare Baugruppe (10) nach Anspruch 1, ferner umfassend den Rahmen (20), wobei der Rahmen (20) konfiguriert ist, im modularen System (5) untergebracht zu sein, wobei die zurückziehbare Vorrichtung (30) konfiguriert ist, sich von einem Inneren des Rahmens (20) zu erstrecken und sich in das Innere des Rahmens (20) zurückzuziehen.

3. Die zurückziehbare Baugruppe (10) nach Anspruch 1, wobei die Zwischenvorrichtung (38) mindestens eins von einem Mikroprozessorchip, einem Schaltchip und einem Mikrocontroller ist.

4. Die zurückziehbare Baugruppe (10) nach Anspruch 1, wobei die Verbindungsvorrichtung (50) eine elektronische Vorrichtung einschließt, die konfiguriert ist, die zurückziehbare Vorrichtung (30) mit mindestens einem von dem Rahmen (10) und dem modularen System (5) elektrisch zu verbinden.

5. Die zurückziehbare Baugruppe (10) nach Anspruch 4, wobei die Verbindungsvorrichtung (50) eine unterbrechungsfreie Verbindung einschließt.

6. Die zurückziehbare Baugruppe (10) nach Anspruch 1, wobei die Verbindungsvorrichtung (50) mindestens eins von einem Lichtwellenleiter und einem optischen Richtfunk einschließt.

7. Die zurückziehbare Baugruppe (10) nach Anspruch 1, wobei die elektronische Vorrichtung (40) mindestens eins von einer Festplattenspeichervorrichtung, einer Festspeichervorrichtung, einem Miniaturcomputer, einem Mikroservermodul, einer Eingangs-/Ausgangsvorrichtung und einem Speicher-Subsystem-Modul ist.

8. Die zurückziehbare Baugruppe (10) nach Anspruch 1, ferner umfassend ein Frontpaneel, das mindestens eins von einer Schaltfläche, einer Anzeige, einer Belüftung und einem Griff enthält.

9. Die zurückziehbare Baugruppe nach Anspruch 1, wobei die zurückziehbare Baugruppe (10) mindestens eins von einem Server und einer Speicher-Shell umfasst.

10. Die zurückziehbare Baugruppe (10) nach Anspruch 1, ferner umfassend einen mechanischen Anschlag, der die Erstreckung der zurückziehbaren Vorrichtung beschränkt.

11. Modulares System (5) für elektronische Vorrichtungen (40), umfassend: einen Rahmen (10) und mehrere zurückziehbare Baugruppen (10) nach Anspruch 1, wobei die mehreren zurückziehbaren Baugruppen (10) im Rahmen (10) untergebracht ist.

## Revendications

1. Ensemble rétractable (10) pour dispositifs électroniques, comprenant : au moins un dispositif rétractable (30) configuré pour s'étendre à partir de et se rétracter dans un châssis (20), le dispositif rétractable (30) comprenant une carte (32) configurée pour supporter au moins un dispositif électronique, et un dispositif de connexion configuré pour former une interface entre le dispositif rétractable (30) et au moins l'un du châssis (20) et d'un composant d'un système modulaire (5) pour recevoir l'ensemble rétractable (10), le dispositif de connexion (50) étant configuré pour maintenir l'interface lorsque le dispositif rétractable est à la fois étendu à partir de et rétracté dans le châssis (20), et **caractérisé par le fait que** ledit ensemble rétractable (10) comprend en outre un dispositif intermédiaire (38) configuré pour réaliser au moins l'une d'une fonction de commande avec le dispositif électronique (40) et d'une fonction de commutation avec le dispositif électronique (40), le dispositif intermédiaire (38) étant connecté à la carte (32) du dispositif rétractable (30) de telle sorte que le dispositif intermédiaire (38) s'étend et se rétracte avec le dispositif rétractable (30).

2. Ensemble rétractable (10) selon la revendication 1, comprenant en outre le châssis (20), le châssis (20) étant configuré pour être reçu à l'intérieur du système modulaire (5), le dispositif rétractable (30) étant configuré pour s'étendre à partir d'un intérieur du châssis (20) et se rétracter dans l'intérieur du châssis (20).

3. Ensemble rétractable (10) selon la revendication 1, dans lequel le dispositif intermédiaire (38) est au moins l'un d'une puce de microprocesseur, d'une puce de commutation et d'un microcontrôleur.

4. Ensemble rétractable (10) selon la revendication 1, dans lequel le dispositif de connexion (50) comprend un dispositif électronique qui est configuré pour connecter électriquement le dispositif rétractable (30) à au moins l'un du châssis (10) et du système modulaire (5).

5. Ensemble rétractable (10) selon la revendication 4, dans lequel le dispositif de connexion (50) comprend une connexion sans rupture.

6. Ensemble rétractable (10) selon la revendication 1, dans lequel le dispositif de connexion (50) comprend au moins l'un d'un guide d'ondes optique et d'une optique sans fil.

7. Ensemble rétractable (10) selon la revendication 1, dans lequel le dispositif électronique (40) est au moins l'un d'un dispositif de stockage à disque dur, d'un dispositif de stockage à mémoire à semiconducteurs, d'un ordinateur miniature, d'un module de microserveur, d'un dispositif entrée/sortie et d'un module de sous-système de mémoire.

8. Ensemble rétractable (10) selon la revendication 1, comprenant en outre un panneau avant qui comprend au moins l'un d'un bouton, d'un dispositif d'affichage, d'un évent et d'une poignée.

9. Ensemble rétractable selon la revendication 1, dans lequel l'ensemble rétractable (10) comprend au moins l'un d'un serveur et d'une enveloppe de stockage.

10. Ensemble rétractable (10) selon la revendication 1, comprenant en outre une butée mécanique qui limite l'extension du dispositif rétractable.

11. Système modulaire (5) pour dispositifs électroniques (40), comprenant : un châssis (10) et une pluralité d'ensembles rétractables (10) selon la revendication 1, la pluralité d'ensembles rétractables (10) étant reçue dans le châssis (10).
